# EUROPÄISCHE PATENTSCHRIFT

(11) **EP 0 787 220 B1**
(45) Veröffentlichungstag und Bekanntmachung des Hinweises auf die Patenterteilung: **09.02.2000**
(21) Anmeldenummer: 95938447.0
(22) Anmeldetag: 17.11.1995
(51) Int. Cl.: C23C 16/02, F16K 25/00

(54) **DICHTUNGSELEMENT, INSBESONDERE FÜR ABSPERR- UND REGELORGANE UND VERFAHREN ZU SEINER HERSTELLUNG**
PACKING ELEMENT, IN PARTICULAR FOR SHUTTING-OFF AND REGULATING MEANS, AND PROCESS FOR PRODUCING THE SAME
ELEMENT D'ETANCHEITE, NOTAMMENT POUR ORGANES D'OBTURATION ET DE REGULATION, ET SON PROCEDE DE FABRICATION

(30) Priorität: 21.11.1994 DE 4441134
(43) Veröffentlichungstag der Anmeldung: 06.08.1997
(73) Patentinhaber: FRIEDRICH GROHE AG, 58653 Hemer (DE)
(72) Erfinder: KLEINHANS, Werner, 59425 Unna (DE); BECHTE, Veit, 59439 Holzwickede (DE); WAGNER, Friedrich, 79346 Endingen (DE)
(74) Vertreter: Pätzold, Herbert, Dr.-Ing.
(86) Internationale Anmeldenummer: EP9504534
(87) Internationale Veröffentlichungsnummer: WO9616200

(56) Entgegenhaltungen:
- DE-A- 3 832 692

## Beschreibung

Die Erfindung bezieht sich auf ein Dichtungselement, insbesondere für Absperr- und Regelorgane. Es besteht aus einem scheibenförmigen, kolbenförmigen oder kugelförmigen Absperrkörper. Der Absperrkörper kann aus einem metallischen oder nichtmetallischen Werkstoff bestehen. Bei diesem Werkstoff kann es sich beispielsweise auch um einen Keramikwerkstoff handeln, wozu auch Aluminiumoxid und die verschiedenen Siliciumcarbide SiC, Si₂C und Siliciumnitrid Si₃N₄ gehören.

Auf einer Arbeitsfläche (Dichtfläche) des Absperrkörpers ist im Wege der Plasma-CVD oder Plasmapolymerisation in einer Beschichtungskammer eine Hartstoffschicht aufgetragen, die Kohlenstoff und Silicium enthält. Dabei umfaßt die Hartstoffschicht einen auf die Arbeitsfläche des Absperrkörpers aufgetragenen Haftschichtanteil und einen anschließenden Deckschicht(Gleitschicht)anteil. Der Haftschichtanteil besitzt einen die Haftung an der Arbeitsfläche des Absperrkörpers begünstigenden ersten Siliciumanteil, und der anschließende kohlenstoffhaltige Deckschichtanteil besitzt zur Erzielung niedriger Gleit- und Haftreibungskoeffizienten einen geringeren zweiten Siliciumanteil als der Haftschichtanteil oder ist siliciumfrei.

Die Abscheidung aus dem Plasma erfolgt durch Ionenbeschuß, z.B. mittels einer Glimmentladung oder durch eine zusätzliche Ionenkanone. Aus einer kohlenwasserstoffhaltigen Atmosphäre kann dabei eine verschleißfeste kohlenstoffhaltige Schicht zur Abscheidung gebracht werden, die ausreichend niedrige Gleit- und Haftreibungskoeffizienten aufweist.

Ein Dichtungselement der vorstehenden Art und das zugehörige Plasma-CVD-Beschichtungsverfahren ist durch die DE-OS 38 32 692 bekannt.

Hiernach werden Absperrkörper zur Beschichtung ihrer Arbeitsflächen auf einem relativ zum Plasma negativ gepolten Probenhalter in der Beschichtungskammer gelegt. Zur anfänglichen physikalischen Ätzung der Arbeitsflächen der Absperrkörper mit Argon wird die Beschichtungsanlage zunächst als Kathodenzerstäubungs(Sputter)-Anlage betrieben. Zur anschließenden Abscheidung des Haftschichtanteils der Hartstoffschicht auf die geätzte Arbeitsfläche wird dieselbe Anlage dann unter bestimmten ersten Prozeßparametern als Hochfrequenz-Plasma-CVD-Anlage betrieben, wobei das Argongas in der Beschichtungskammer, z.B. durch Tetramethylsilan ersetzt wird. Unter geänderten zweiten Prozeßparametern wird anschließend nach der Abscheidung des Haftschichtanteils der Deck- bzw. Gleitschichtanteil aus einem Gasgemisch aus Tetramethylsilan und Hexan abgeschieden.

Die hiernach erhaltenen Dichtungselemente (es kann sich vorteilhafterweise um beschichtete Keramikscheiben für Wasserarmaturen, z.B. Einhandmischer, handeln) besitzen dank der aufgetragenen Hartstoffschicht auch in Gegenwart von Wasser beim Aufeinandergleiten ausreichend niedrige Gleit- und Haftreibungskoeffizienten, so daß ein Einfetten der Dichtungsflächen nicht länger notwendig ist, wie es bislang bei unbeschichteten Keramikscheiben erforderlich war.

Nachteilig ist bei den bekannten Dichtungselementen, daß ihre Heißwasserbeständigkeit vielfach unbefriedigend ist. Das gilt insbesondere dann, wenn eine Heißwasserbeständigkeit von mehr als 1000 Betriebsstunden erreicht werden soll, ohne daß die aufgetragene Hartstoffschicht sich vom Absperrkörper ablöst.

Aufgabe der Erfindung ist es, eine Dichtungselement der eingangs genannten Art anzugeben, das bei ausreichend niedrigen Haft- und Gleitreibungskoeffizienten an der Gleitschichtoberfläche eine hohe Heißwasserbeständigkeit aufweist. Bevorzugte Dichtungselemente, insbesondere in Scheibenform sollen eine Heißwasserbeständigkeit bei 95°C über einen Betriebszeitraum von mindestens 1000 h haben, ohne daß vor allem die Haftung der Hartstoffschicht am Absperrkörper wesentlich in Mitleidenschaft gezogen wird.

Die Aufgabe wird erfindungsgemäß mit den kennzeichnenden Merkmalen des Anspruches 1 gelöst. Vorteilhafte Ausführungen und Weiterbildungen ergeben sich aus den Merkmalen der Ansprüche 2 bis 8.

Es war erfinderseits überraschend, daß ein optimiertes Schichtdickenverhältnis von Haft- und Gleitschichtanteil durch Wahl der Abscheidungszeiten in der Beschichtungskammer die Haftungseigenschaften des Haftschichtanteils am Absperrkörper unter Heißwasserbedingungen wesentlich zu verbessern vermag und daß darüber hinaus diese Haftungseigenschaften des Haftschichtanteils- noch weiter erhöht werden können, wenn das Dichtungselement mit optimiertem Haft-/Gleitschichtverhältnis zusätzlich noch getempert wird, wobei Temperaturen bei etwa 500°C während 30 bis 60 min und Temperaturen bei etwa 900°C während 0,5 bis 1 min zu besonders guten Ergebnissen führten.

Es hat sich herausgestellt, daß wenn erfindungsgemäß den Gleitschichtanteil weitgehend dünn gewählt wird, dann können die Eigenspannungen des Gleitschichtanteils durch einen ausreichend dicken Haftschichtanteil gut aufgenommen werden, ohne daß dessen Haftungsvermögen an dem Absperrkörper auch unter langzeitiger Heißwasserbeanspruchung nennenswert beansprucht wird. Besonders gute Ergebnisse lassen sich erzielen, wenn das Dickenverhältnis in µm von Haftschichtanteil und Gleitschichtanteil 1:0,9 bis 1:0,4, vorzugsweise 1:0,6 beträgt.

Das optimale Haft-/Gleitschichtverhältnis kann auch durch die Wahl der Gase mitbeeinflußt sein, aus denen die Haft- und Gleitschichtanteile abgeschieden sind. So kann es vorteilhaft sein, zur Abscheidung des Haftschichtanteils Tetramethylsilan und zur Abscheidung des Gleitschichtanteils ein Gasgemisch aus Tetramethylsilan und Hexan zu wählen, wobei das Mischungsverhältnis Tetramethylsilan zu Hexan im Bereich von 1:1,5 bis 1:5, vorzugsweise 1:2 ist. Es ist klar, daß Tetramethylsilan und Hexan durch vergleichbare Gase ersetzt sein können.

Damit der Haftschichtanteil die Eigenspannungen des relativ harten und spröden Gleitschichtanteils aufzunehmen vermag, besitzt dieser gegenüber dem Gleitschichtanteil erhöhte plastische bzw. duktile Eigenschaften. Diese dehnbaren, verformbaren Eigenschaften werden beim Abscheiden des Haftschichtanteils dadurch erzielt, daß das Verhältnis von Silicium/Kohlenstoff/Wasserstoff von dem entsprechenden Verhältnis im Gleitschichtanteil deutlich unterschiedlich gewählt ist. So ist der Siliciumanteil im Haftschichtanteil deutlich höher als im Gleitschichtanteil gewählt und entsprechend ist der Kohlenstoffanteil im Haftschichtanteil deutlich niedriger als im Gleitschichtanteil gewählt, um eine ausreichende Duktilität bei einer bestimmten Schichtdicke des Haftschichtanteils sicherstellen zu können.

Durch die Prozeßführung beim Abscheiden des Haftschichtanteils und des anschließenden Gleitschichtanteils wird vorteilhafterweise ein fließender Übergang vom Haftschichtanteil zum Gleitschichtanteil vorgenommen, wobei die unterschiedlichen Silicum/Kohlenstoff/Wasserstoffanteile in den Haft- und Gleitschichtanteilen einander stufenweise oder kontinuierlich angepaßt werden.

Die Erfindung wird ohne jede Beschränkung anhand eines Ausführungsbeispieles beschrieben.

Zur Beschichtung wird eine Beschichtungskammer verwendet, die im wesentlichen der Beschichtungskammer entspricht, wie sie bereits in der DE-OS 38 32 692 gezeigt ist.

Die bekannte Beschichtungskammer besteht im Prinzip aus einem elektrisch-leitenden Kammerboden, an dem ein ebenfalls elektrisch-leitendes, allseits abgeschlossenes Kammergehäuse angeschlossen ist. Der Kammerboden besitzt einen isolierten Anschluß für eine Durchführung, die eine Verbindung zwischen der als Kathodenauflage dienenden Kathode und einer elektrischen Versorgung in der Gestalt einer Hochfrequenzeinrichtung herstellt. Auf die Kathodenauflage werden die Absperrkörper mit der zu beschichtenden Fläche nach oben gelegt. Im vorliegenden Fall handelt es sich, ohne Einschränkung, um Al₂O₃-Keramikscheiben für Hydraulikarmaturen.

Der Kammerboden besitzt außerdem einen zweiten Anschluß für ein Absaugrohr, das an eine Vakuumpumpstation angeschlossen ist. Schließlich besitzt der Kammerboden Anschlüsse für die Zuleitung von Prozeßgasen in die Beschichtungskammer.

Zunächst wird die Vakuumstation eingeschaltet und in der Beschichtungskammer wird ein Druck von etwa 8 x 10⁻⁵ mbar (= 0,08 Mbar) eingestellt. Anschließend wird über ein Gaszuleitungsrohr Argon in die Beschichtungskammer eingeleitet bis ein Gasdruck von etwa 6 µbar erreicht ist. Sodann wird die Hochfrequenzeinrichtung eingeschaltet und die Glimmentladung gezündet. Dabei wird eine Kathodengleichspannung von etwa 600 V eingestellt. Hierbei arbeitet die Beschichtungskammer zunächst als Kathodenzerstäubungs-(Sputter)anlage, in der die Kathodenauflage und die auf ihr liegenden Keramikscheiben durch Ionenbeschuß etwa 15 bis 25 min, vorzugsweise 20 min lang physikalisch geätzt werden.

Bereits etwas vor dem Ende der Ätzperiode wird der Zufluß von Argon in die Kammer stufenweise gedrosselt und gleichzeitig Tetramethylsilan (TMS) der Kammer stufenweise in zunehmenden Maße zugeführt, um dadurch einen möglichst weichen Übergang zum Haftschichtanteil der Hartstoffschicht zu erhalten.

Bei einer verringerten Kathodenspannung von etwa 500 V wird der Haftschichtanteil etwa 25 bis 30 min lang bis zu einer Stärke von etwa 1 µm aufgetragen. Anschließend wird der Gleitschichtanteil auf dem Haftschichtanteil zur Abscheidung gebracht, wobei ein Gasgemisch von Tetramethylsilan zu Hexan im Verhältnis von 1:1,5 bis 1:5, vorzugsweise 1:2 verwendet wird. Um auch einen weichen Übergang von Haftschichtanteil zum Gleitschichtanteil zu erhalten, wird die TMS-Zufuhr während einer Übergangszeit stufenweise gedrosselt und entsprechend wird stufenweise die Zufuhr von Hexan gesteigert, bis das gewählte TMS/Hexangemisch erreicht ist.

Die Beschichtungszeit für den Gleitschichtanteil beträgt etwa 10 bis 15 min, um dabei eine Schichtdicke von etwa 0,4 bis 0,9 µm, vorzugsweise 0,6 µm zu erhalten.

Bei einem Schichtdickenverhältnis von Haftschichtanteil zu Gleitschichtanteil von 1 µm zu 0,6 µm werden die erhöhten Eigenspannungen des Gleitschichtanteils von dem Haftschichtanteil bereits gut aufgenommen, ohne daß darunter die Haftfähigkeit des Haftschichtabschnittes an der Arbeitsfläche des Keramikkörpers leidet.

Die guten Haftbedingungen des Haftschichtanteils können noch dadurch weiter verbessert werden, daß die beschichteten Keramikkörper einer Wärmenachbehandlung unterzogen werden. Besonders gute Ergebnisse werden erzielt, wenn die beschichteten Keramikkörper 30 bis 60 min lang bei etwa 500°C oder 0,5 bis 1 min lang bei etwa 900°C getempert werden.

## Patentansprüche

1. Dichtungselement, insbesondere für Absperr- und Regelorgane, bestehend aus einem plattenförmigen, kolbenförmigen oder kugelförmigen Absperrkörper aus einem metallischen oder nicht-metallischen Werkstoff, beispielsweise Keramikwerkstoff, mit einer auf der als Dichtfläche ausgebildeten Arbeitsfläche des Absperrkörpers im Wege der Plasma-CVD oder Plasmapolymerisation im µm-Bereich aufgetragenen Hartstoffschicht, die Kohlenstoff und Silicium enthält und wobei die Hartstoffschicht aus einem an die Arbeitsfläche des Absperrkörpers angrenzenden inneren Haftschichtanteil und einem anschließenden als Gleitschicht ausgebildeten äußeren Deckschichtanteil besteht und wobei der kohlenstoffhaltige Haftschichtanteil einen ersten Siliciumanteil und der kohlenstoffhaltige Deckschichtanteil einen geringeren zweiten Siliciumanteil als der Haftschichtanteil aufweist oder siliciumfrei ist,
**dadurch gekennzeichnet,**
daß der Haftschichtanteil gegenüber dem weitgehend dünn gewählten spröden, harten Deckschichtanteil vergleichsweise dick ist und eine vergleichsweise höhere Duktilität besitzt.

2. Dichtungselement nach Anspruch 1, dadurch gekennzeichnet, daß die Dicke des Deckschichtanteils kleiner als 1 µm ist.

3. Dichtungselement nach Anspruch 1, dadurch gekennzeichnet, daß das Dickenverhältnis von Haftschichtanteil zu Deckschichtanteil 1:0,9 bis 1:0,4 ist.

4. Dichtungselement nach Anspruch 3, dadurch gekennzeichnet, daß das Dickenverhältnis von Haftschichtanteil zu Deckschichtanteil 1:0,6 ist.

5. Verfahren zur Herstellung des Dichtungselementes nach Anspruch 1, dadurch gekennzeichnet, daß die Schichtdicken der Deck- und der Haftschichtanteile durch die Wahl der Zeitparameter beim Abscheiden der Schichten in der CVD-Beschichtungskammer eingestellt werden.

6. Verfahren nach Anspruch 5, dadurch gekennzeichnet, daß das erste Prozeßgas zur Abscheidung des Haftschichtanteils ein Silan ist und das zweite Prozeßgas zur Abscheidung des Deckschichtanteils ein Gasgemisch aus dem Silan und einem Kohlenwasserstoffgas ist, wobei das Verhältnis von Silan zum Kohlenwasserstoffgas im Bereich von 1:1,5 bis 1:5 liegt.

7. Verfahren nach Anspruch 6, dadurch gekennzeichnet, daß das Silan/Kohlenwasserstoffverhältnis 1:2 ist.

8. Verfahren nach Anspruch 6, dadurch gekennzeichnet, daß die zu beschichtende Arbeitsfläche des Absperrkörpers mit Argon etwa 15 bis 25 min, vorzugsweise 20 min geätzt wird, wobei die Beschichtungsanlage als Kathodenzerstäubungs anlage betrieben wird, daß anschließend zum Auftragen des Haftschichtanteils und darauf des Deckschichtanteils der Hartstoffschicht die Beschichtungsanlage als Hochfrequenz-Plasma-CVD-Anlage betrieben wird, wobei 25 bis 20 min lang der Haftschichtanteil aus Tetramethylsilan und anschließend 10 bis 15 min lang der Deckschichtanteil aus einem Gasgemisch aus Tetramethylsilan und Hexan im Verhältnis von 1:1,5 bis 1:5 abgeschieden wird, und wobei das Schichtdicken verhältnis von Haftschichtanteil zu Deckschichtanteil 1:0,9 bis 1:0,4 beträgt.

## Claims

1. Packing element, in particular for shutting-off and regulating means, consisting of a plate-shaped, piston-shaped or spherical shut-off body made of a metallic or non-metallic material, for example a ceramics material, and having a hard material layer applied to the working surface, configured as a sealing surface, of the shut-off body by means of a plasma CVD process or plasma polymerisation in the µm range, which layer contains carbon and silicon and consists of an inner adhesive layer portion adjacent to the working surface of the shut-off body and a connecting outer cover layer portion configured as a slide layer, the adhesive layer portion, containing carbon, having a first silicon portion and the cover layer portion, containing carbon, having a smaller second silicon portion than the adhesive layer portion or being silicon-free,
**characterised in that**
the adhesive layer portion is relatively thick in comparison with the brittle, hard and extensively thin cover layer portion, and has comparatively higher ductility.

2. Packing element according to claim 1, **characterised in that** the thickness of the cover layer portion is smaller than 1 µm.

3. Packing element according to claim 1, **characterised in that** the thickness ratio of adhesive layer portion to cover layer portion is 1:0.9 to 1:0.4.

4. Packing element according to claim 3, **characterised in that** the thickness ratio of adhesive layer portion to cover layer portion is 1:0.6.

5. Method of manufacturing the packing element according to claim 1, **characterised in that** the layer thicknesses of the cover and adhesive layer portions are set by the choice of the time parameters for the deposition of the layers in the CVD coating chamber.

6. Method according to claim 5, **characterised in that** the first process gas for depositing the adhesive layer portion is a silane, and the second process gas for depositing the cover layer portion is a gas mixture of silane and a hydrocarbon gas, the ratio of silane to hydrocarbon gas lying in the range between 1:1.5 and 1:5.

7. Method according to claim 6, **characterised in that** the silane/hydrocarbon ratio is 1:2.

8. Method according to claim 6, **characterised in that** the working surface, to be coated, of the shut-off body is etched with argon for roughly 15 to 25 min, preferably 20 min, the coating plant being operated as a cathode sputtering plant, in that then, to apply the adhesive layer portion and upon it the cover layer portion of the hard material layer, the coating plant is operated as a high frequency plasma CVD plant, the adhesive layer portion being deposited for 25 to 20 min from tetramethylsilane and then the cover layer portion being deposited for 10 to 15 min from a gas mixture of tetramethylsilane and hexane in the ratio of 1:1.5 to 1:5, and the layer thickness ratio of adhesive layer portion to cover layer portion being 1:0.9 to 1:0.4.

## Revendications

1. Élément d'étanchéité, notamment pour organes d'obturation et organes de régulation, constitué d'un corps d'obturation en forme de plaquette, en forme de piston ou en forme de sphère, en une matière métallique ou non métallique, par exemple une matière céramique, comportant une couche de matière dure qui est déposée sur la surface de travail du corps d'obturation, réalisée en tant que surface d'étanchéité, au moyen d'un dépôt en phase gazeuse par procédé chimique au plasma ou d'une polymérisation de plasma dans le domaine des µm, et qui contient du carbone et du silicium, la couche de matière dure étant constituée d'une partie intérieure formant couche d'adhérence, adjacente à la surface de travail du corps d'obturation, et, adjacente à cette partie intérieure, une partie extérieure formant couche de couverture, réalisée en tant que couche de glissement, la partie formant couche d'adhérence, contenant du carbone présentant une première proportion de silicium et la partie formant couche de couverture, contenant du carbone, présentant une seconde proportion de silicium plus faible que la partie formant couche d'adhérence ou étant dépourvue de silicium,
caractérisé
en ce que la partie formant couche d'adhérence est relativement épaisse en comparaison de la partie formant couche de couverture, dure et fragile, qui est choisie avec une grande minceur et en ce qu'elle possède une ductilité relativement plus élevée.

2. Élément d'étanchéité suivant la revendication 1, caractérisé en ce que l'épaisseur de la partie formant couche de couverture est inférieure à 1 µm.

3. Elément d'étanchéité suivant la revendication 1, caractérisé en ce que le rapport des épaisseurs de la partie formant couche d'adhérence à la partie formant couche de couverture est de 1:0,9 à 1:0,4.

4. Elément d'étanchéité suivant la revendication 3, caractérisé en ce que le rapport des épaisseurs de la partie formant couche d'adhérence à la partie formant couche de couverture vaut 1:0,6.

5. Procédé de fabrication d'un élément d'étanchéité suivant la revendication 1, caractérisé en ce que les épaisseurs de couche de la partie formant couverture et de la partie formant couche d'adhérence sont réglées au moyen du choix des paramètres de temps lors du dépôt des couches dans la chambre de revêtement par dépôt en phase vapeur par procédé chimique.

6. Procédé suivant la revendication 5, caractérisé en ce que le premier gaz de processus servant au dépôt de la partie formant couche d'adhérence est un silane et le second gaz de processus servant au dépôt de la partie formant couche de couverture est un mélange gazeux de silane et d'un hydrocarbure gazeux, le rapport du silane à l'hydrocarbure gazeux étant situé dans la fourchette de 1:1,5 à 1:5.

7. Procédé suivant la revendication 6, caractérisé en ce que le rapport silane/hydrocarbure vaut 1:2.

8. Procédé suivant la revendication 6, caractérisé en ce qu'on décape à l'argon la surface de travail à revêtir du corps d'obturation pendant environ 15 à 25 minutes, de préférence 20 minutes, en faisant fonctionner l'installation de revêtement en installation de pulvérisation cathodique, et en ce qu'ensuite, pour le dépôt de la partie formant couche d'adhérence et, par-dessus, de la partie formant couche de couverture de la couche de matière dure, on fait fonctionner l'installation de revêtement en installation de dépôt en phase vapeur par procédé chimique au plasma à haute fréquence, la partie formant couche d'adhérence étant déposée à partir de tétraméthylsilane pendant 25 à 20 minutes et, ensuite, la partie formant couche de couverture étant déposée à partir d'un mélange gazeux de tétraméthylsilane et d'hexane pendant 10 à 15 minutes, dans un rapport de 1:1,5 à 1:5, le rapport des épaisseurs de couche de la partie formant couche d'adhérence à la partie formant couche de couverture valant 1:0,9 à 1:0,4.
